# EUROPEAN PATENT APPLICATION

(11) **EP 1 033 741 A2**
(43) Date of publication of application: **06.09.2000**
(21) Application number: 99121673.0
(22) Date of filing: 02.11.1999
(51) Int. Cl.: H01J 37/317, H01J 37/04

(54) **Charged-particle beam lithography system**

(30) Priority: 02.03.1999 JP 5412499
(71) Applicant: Advantest Corporation, Tokyo 179-0071 (JP)
(72) Inventor: Maruyama, Shigeru, c/o Advantest Corporation, Tokyo, 179-0071 (JP); Ooae, Yoshihisa, c/o Advantest Corporation, Tokyo, 179-0071 (JP); Satoh, Takamasa, c/o Advantest Corporation, Tokyo, 179-0071 (JP); Arai, Souichiro, c/o Advantest Corporation, Tokyo, 179-0071 (JP); Hashimoto, Shinichi, c/o Advantest Corporation, Tokyo, 179-0071 (JP)
(74) Representative: Tetzner, Michael

(57) **Abstract**

Disclosed is a charged-particle beam lithography system of a blanking aperture array type offering improved reliability and enabling drawing of microscopic LSI patterns with high quality at low cost. The charged-particle beam lithography system has a beam source, a blanking aperture array, a deflection unit, a convergence unit, and an exposure control circuit. The blanking aperture array has a plurality of apertures and electrodes each pair of which is mutually opposed on each aperture. Using an on-off signal to be applied to a deflection electrode on each aperture, it can be determined whether a charged-particle beam passing through each aperture in the blanking aperture array is irradiated onto a sample. The deflection unit deflects the charged-particle beam passing through the blanking aperture array. The convergence unit converges the charged-particle beam passing through the blanking aperture array on the sample. The exposure control circuit controls a signal to be applied to the electrodes on the apertures in the blanking aperture array according to an exposure pattern. The blanking aperture array has a plurality of layered BAA substrates. Each BAA substrate has a plurality of apertures bored therein and has deflection electrodes formed on one side thereof.

## Description

### BACKGROUND OF THE INVENTION

### 1. Field of the Invention

The present invention relates to a charged-particle beam lithography system such as an electron beam lithography system. More particularly, the present invention is concerned with a BAA type charged-particle beam lithography system having a blanking aperture array (BAA) and controlling the BAA synchronously with a sweep of a charged-particle beam. The BAA has numerous apertures, on each of which a control electrode is formed, arranged therein, and controls the on and off states of a beam passing through each of the apertures by applying a signal to each of the control electrodes.

### 2. Description of the Related Art

In resent years, semiconductor technologies have developed progressively to improve the degree of integration of and functions offered by, semiconductor integrated circuits (ICs). Semiconductor technologies are expected to play a pivotal role in advancing a wide range of technologies relevant to all industries such as technologies of computing, controlling communication machines, and so on. ICs have come to enjoy a four-fold degree of integration in the last two or three years. For example, the storage capacity offered by dynamic random access memories (DRAMs) has expanded to be 1 megabyte, 4 megabytes, 16 megabytes, 256 megabytes, and finally 1 gigabyte. The trend of ICs towards a high degree of integration is dependent greatly on the advancement in a microprocessing technology included in semiconductor manufacturing technologies.

Currently the limiting factor in microprocessing technology is pattern lithography technology. A photolithography method referred to as a step-and-repeat photolithography method with demagnification is currently adopted as a lithography technology for drawing patterns. According to the photolithography method, the smallest width of a pattern that can be drawn is restricted to a wavelength permitted by an exposure light source because of diffraction. At present, a source for outputting ultraviolet rays is used as the light source. There is a difficulty in adopting light of a shorter wavelength. To achieve finer processing, studies have been made on a novel lithography method other than the photolithography method.

It is known that a charged-particle beam lithography method makes it feasible to attain a resolution of 0.05 micrometers or less while ensuring alignment precision of 0.02 micrometers or less. However, the charged-particle beam lithography method has been thought to be unusable for mass production of LSIs because of a low throughput rate that is lower than that offered by the step-and-repeat photolithography method with demagnification.

The question of the throughput rate offered by the charged-particle beam lithography method gives rise to a problem in an electron beam lithography method adopting one stroke drawing technique. According to the electron beam lithography method, for example, one particle beam (electron beam) is swept continuously during exposure. In other words, when it is said that the charged-particle beam lithography method cannot be adopted for mass production of LSIs because of the low throughput, it is judged from the productive capacity of a currently locally procurable system. A block lithography method (a method of transferring part of a graphic at a time or a repetitive pattern at a time and exposing the remaining part in units of a variable rectangle) has been devised in recent years. Owing to the block lithography method, a high throughput can be expected for production of a device requiring drawing of many repetitive patterns, such as, a memory. However, as far as a device having random patterns drawn thereon such as a logic circuit is concerned, adoption of the block lithography method yields little merit. Improvement of the throughput rate is still hard to achieve. There is therefore an increasing demand for development of a new charged-particle beam lithography method offering a high throughput for production of a device having random patterns drawn thereon.

According to conventional charged-particle beam lithography methods, a single charged-particle beam is used for exposure. Even in the block lithography method, a single charged-particle beam must be used to draw random patterns. The throughput rate cannot therefore be improved very much. Moreover, when the block lithography method is adopted to produce a variety of devices in small lot, numerous block patterns must be prepared. The increase in the number of block patterns limits the range of application of the block lithography method. Under the circumstances, a proposal has been made of a multi-beam lithography method according to which a plurality of charged-particle beams, which are produced using a blanking aperture array (BAA) and are independently controllable, is used for exposure. The present invention relates to a multi-beam charged-particle beam lithography system using the BAA. Herein, this kind of lithography method will be referred to as a blanking aperture array (BAA) lithography method. The blanking aperture array lithography method will be described by taking an electron beam lithography system, which uses an electron beam as a charged-particle beam, for instance.

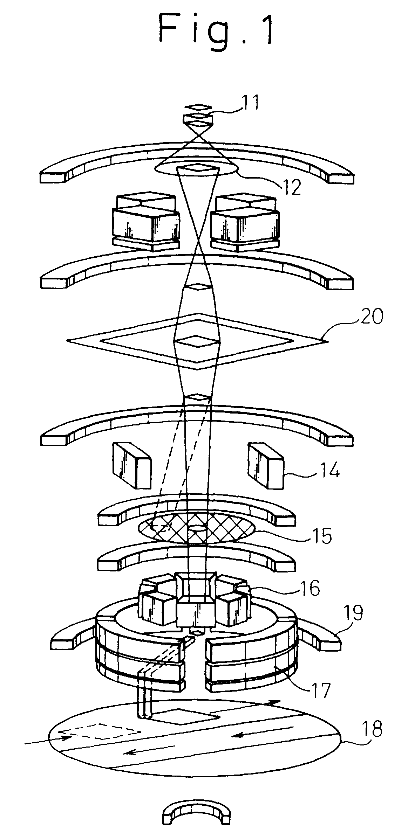

Fig. 1 shows the basic configuration of an optical system included in a BAA electron beam lithography system. Referring to Fig. 1, an electron beam radiated from an electron gun 11 is reshaped by a first rectangular aperture 12. After the electron beam is recomposed into a parallel-ray beam by means of an electromagnetic lens and so on, it falls on a BAA device 20. As described later, the electron beam incident on the BAA device 20 becomes numerous minute beams that are independently controllable in terms of whether each minute beam is irradiated onto a sample (wafer). A blanker 14 is realized with an electrostatic deflector for deflecting the numerous minute beams coming out of the BAA device 20 when the minute beams must be intercepted (turned off) simultaneously. When the minute beams are deflected, they are intercepted and brought to an off state by a last aperture 15. When the minute beams are not deflected, they pass through the last aperture and enter an on state. The numerous minute beams coming out of the last aperture 15 are deflected by a sub deflector 16 and a main deflector 17, and irradiated to a desired position on the sample (wafer) 18 placed on a stage. Moreover, the numerous minute beams are converged at a small spot on the sample 18 by means of an electromagnetic lens (composed of a coil 19 that is not shown and pole pieces that are not shown) 19. These components are accommodated by a housing referred to as an optical column. A portion of the housing through which an electron beam passes is depressurized to a vacuum state.

An actual electron beam lithography system includes an exposure control circuit, a drive circuit, and an electronic control circuit, though the circuits are not shown in Fig. 1. Herein, the exposure control circuit generates a signal to be applied to electrodes on the BAA device 20 according to an exposure pattern or a deflection signal to be applied to the sub deflector 16 and main deflector 17. The drive circuit applies a signal output from the exposure control circuit to components concerned. An electronic control circuit such as a stage control circuit controls the movements made by the stage.

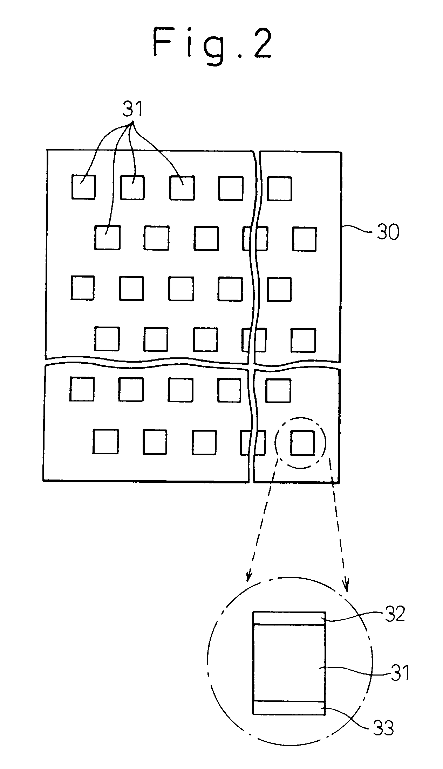

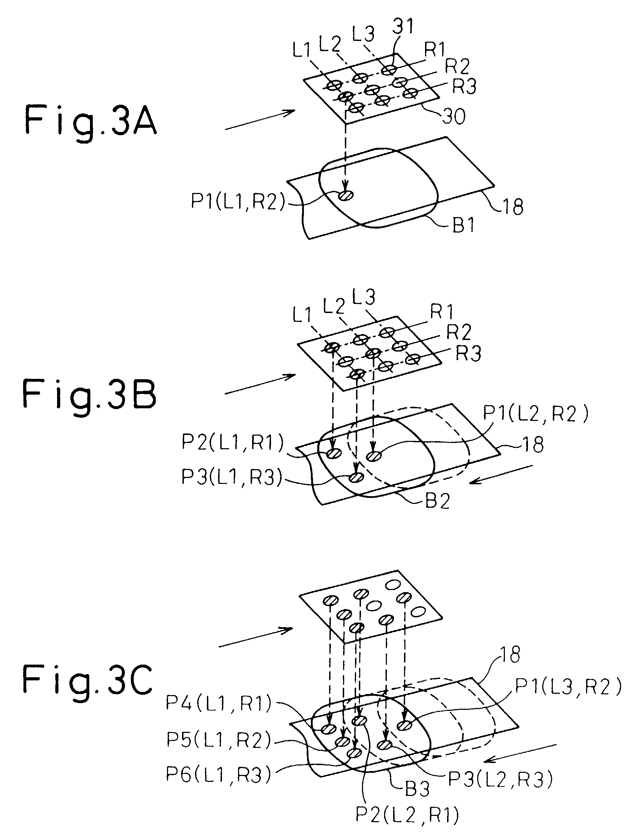

Next, the principles of the blanking aperture array (BAA) method will be described with reference to Fig. 2 and Fig. 3A to Fig. 3C. Fig. 2 shows an example of configurations of a BAA unit 30 having a BAA arranged therein and being included in the BAA device 20. The BAA unit 30 is formed with a thin plate having numerous apertures 31 held therein as illustrated. A deflection signal electrode (deflection electrode) 32 and a ground potential electrode (ground electrode) 33 are formed on both edges of each of the numerous apertures 31. When a homogenous electron beam falls on the BAA unit, numerous minute beams coming out of the apertures 31 are produced. Moreover, each pair of electrodes 32 and 33 realizes an electrostatic deflector. When no voltage is applied to the electrodes 32, the minute beams come out of the apertures as they are, and are then irradiated to the wafer 18. In contrast, when a voltage is applied to the electrodes 32, the minute beams are angled but not irradiated to the wafer 18. The on and off states of the beams coming out of the apertures 31 can be controlled depending on whether or not a voltage is applied to the electrodes 32. Herein, a state in which, because a voltage is applied to the electrodes 32, the minute beams are deflected but are not irradiated to the wafer, is regarded as the off state of the beams. A state in which, because a voltage is not applied to the electrodes 32, the minute beams are not deflected but are irradiated to the wafer 18, is regarded as the on state of the beams.

According to the BAA lithography method, the on and off states of the beams coming out of the apertures in the BAA unit 30 are controlled synchronously with deflection of a group of minute beams in order to draw desired exposure patterns. Fig. 3A to Fig. 3C are explanatory diagrams concerning the BAA lithography method. In the drawings, nine apertures 31 are bored in three columns and three rows in the BAA unit 30. As shown in Fig. 3A, the minute beams coming out of the BAA unit 30 are deflected so that they will be irradiated to an area B1. At this time, assuming that a minute beam coming out of an aperture (L1, R2) alone is on and the other minute beams are off, the minute beam coming out of the aperture (L1, R2) is irradiated to a position P1 (L1, R2) on the sample 18. Thereafter, with the progress of scanning, the minute beams coming out of the BAA unit 30 are deflected so that they will be irradiated to an area B2. Assuming that the minute beams coming out of the apertures (L2, R2), (L1, R1), and (L1, R3) alone are on and the other minute beams are off, the minute beams coming out of the apertures (L2, R2), (L1, R1), and (L1, R3) alone are irradiated to positions P1(L2, R2), P2(L1, R1), and P3(L1, R3) on the sample 18. Between the first and second times of irradiation, the sample is shifted so that the position P1(L2, R2) will coincide with the position P1(L1, R2). With the further progress of scanning, as shown in Fig. 3C, the minute beams coming out of the BAA unit 30 are deflected so that they will be irradiated to an area B3. Assuming that the minute beams coming out of the apertures (L3, R2), (L2, R1), (L2, R3), (L1, R1), (L1, R2), and (L1, R3) are on and the minute beams coming out of the other apertures are off, the minute beams coming out of the apertures (L3, R2), (L2, R1), (L2, R3), (L1, R1), (L1, R2), and (L1, R3) alone are irradiated to positions P1(L3, R2), P2(L2, R1), P3(L2, R3), P4(L1, R1), P5(L1, R2), and P6(L1, R3) on the sample 18. Between the second and third times of irradiation, the sample is shifted so that the position P1(L3, R2) will coincide with the position P1(L2, R2), the position P2(L2, R1) will coincide with the position P2(L1, R1), and the position P3(L2, R3) will coincide with the position P3(L3, R3) respectively.

In a subsequent area, the spots to which the minute beams coming out of the apertures on column L2 shown in Fig. 3C are irradiated are exposed to minute beams coming out of the apertures on column L3. Sweeping of the beam progresses in the meantime. Owing to this movement, any position on the sample can be exposed by a length corresponding to a range of scanning and a width determined with the rows of apertures in the BAA unit 30. At this time, each spot on the sample is exposed the same number of times as the number of columns of apertures. By the way, the apertures 31 in Fig. 2 are arranged in a zigzag pattern. When the wafer shown in Fig. 2 is scanned lengthwise, spots constituting each row become continuous and are therefore exposed in a uniform manner.

As mentioned above, the BAA lithography method makes it possible to expose any spots on a sample freely. In addition to this advantage, since a scan signal should merely be varied continuously, a settlement time required for settling a beam in a vector scanning mode becomes unnecessary. Consequently, scanning can be achieved quickly and exposure can be achieved high efficiently. Moreover, since the same position is exposed a plurality of times, high energy can be exerted for exposure.

In general, a response speed exhibited by a sub deflector is higher than that exhibited by a main deflector. A range of main deflection covered by the main deflector is usually divided into a plurality of ranges of sub deflection each of which is smaller than a range of deflection covered by the sub deflector. A position of deflection to which a beam is is deflected by the main deflector is set to coincide with the center of each range of sub deflection. In this state, an area on a sample defined by the range of sub deflection is exposed for patterning by changing a position of deflection to which each beam is deflected by the sub deflector. When an area on a sample defined with one range of sub deflection has been exposed, the position of deflection to which each beam is deflected by the main deflection is changed and the next area defined by the range of sub deflection is exposed. Another method is a continuous moving method according to which a stage is moved continuously for exposure. According to this method, the position of deflection to which light is deflected by the main deflector is changed synchronously with movement of the stage, and areas on a sample defined by the range of sub deflection are exposed successively.

Next, the BAA device 20 actually employed will be described. Fig. 4 shows the overall appearance of the BAA device 20. Fig. 5 is an enlarged view of the apertures in the BAA device 20. Fig. 6 is a sectional view of the BAA device 20, showing two apertures alone.

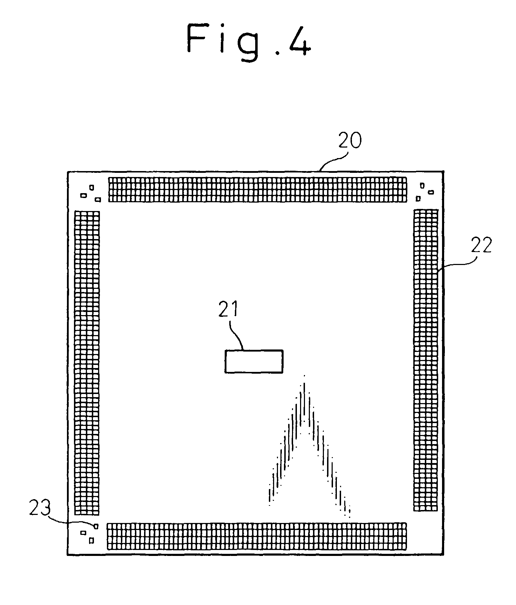

As shown in Fig. 4, the BAA device 20 is formed with a thin plate, for example, a silicon wafer. An aperture portion 21 is formed in the center of the BAA device. The aperture portion of the plate is thinned by performing etching or the like. There is shown deflection electrode pads 22 through which a deflection signal is applied to the deflection electrodes on the apertures. Ground electrode pads 23 are connected to the ground electrodes on the apertures.

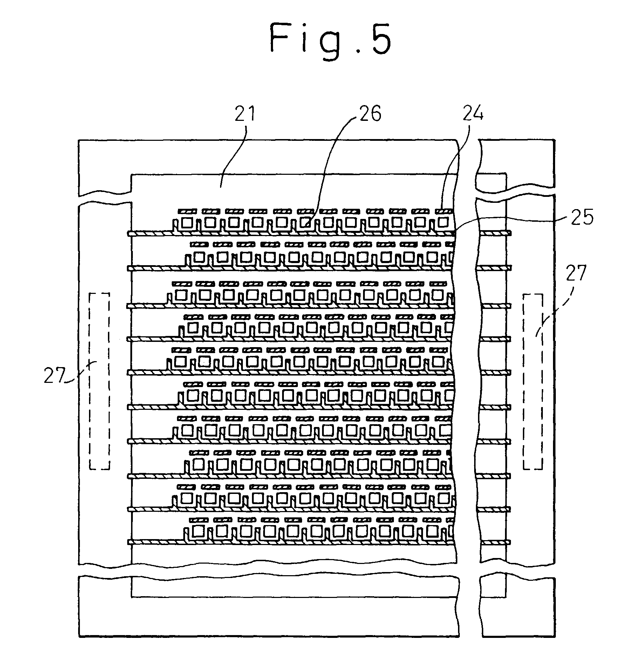

As shown in Fig. 5, the aperture portion 21 has apertures 26 formed along straight lateral lines with a predetermined pitch between sideways adjoining ones. The apertures 26 are arranged longitudinally in zigzag with a displacement of a half pitch between lengthwise adjoining ones. The number of apertures 26 is, for example, 512. A deflection electrode 24 is formed on the upper side of each aperture 26, and a ground electrode 25 is formed along the three remaining sides thereof. The ground electrodes 25 are mutually linked sideways. This structure of electrodes is adopted for fear a voltage applied to the deflection electrode 24 on each aperture may affect another aperture. Through holes 27 are bored in order to link the wirings on both the surface and back of the BAA device.

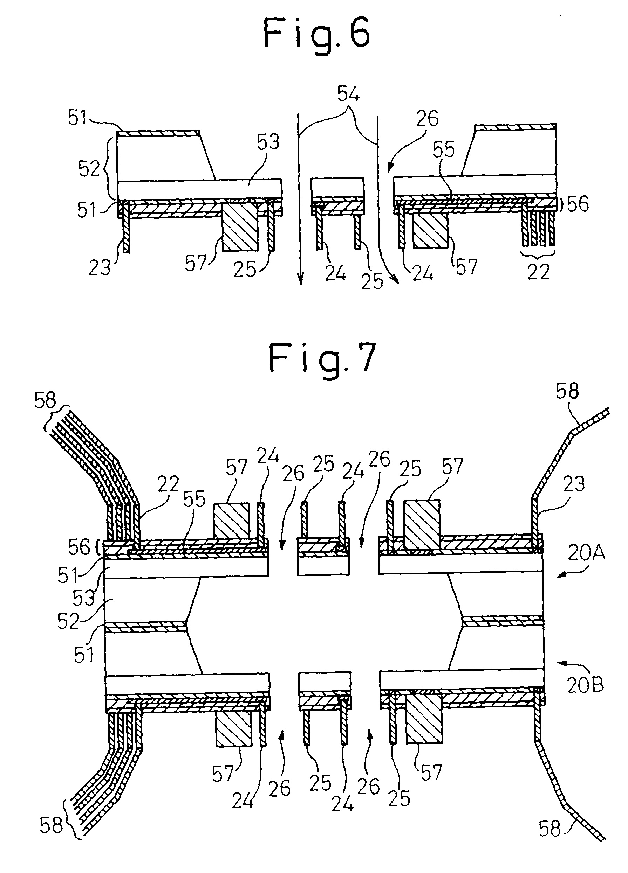

Referring to Fig. 6, the BAA device 20 has the surface insulated. Specifically, boron (B) is diffused into the back of a silicon (Si) substrate 52 in order to produce a boron diffused layer 53. The aperture portion 21 of the substrate is etched in order to further reduce the thickness of the aperture portion 21, and a thermal oxide is formed on both sides of the substrate. Thus, the surface of the substrate is insulated. Specific parts of the aperture portion 21 are etched away in order to form the apertures 26. A wiring layer 56 is formed on the back of the substrate. The deflection electrodes 24 and ground electrodes 25 are then formed on the apertures. Plasma chemical vapor deposition (CVD) is then performed in order to form an oxide. The deflection electrode pads 22, ground electrode pads 23, and ground wiring are formed thereafter. The boron-diffused layer 53 is grounded so that an intercepted electron beam (flow of electrons) will flow into the ground.

When an electron beam 54 is irradiated to the surface of the BAA device 20 having the foregoing structure, the electron beam passes through the apertures 26 alone. This results in the same number of minute beams as the number of apertures 26. Probes extending a probe card come into contact with the deflection electrode pads 22. A signal sent from a BAA drive circuit is applied to the deflection electrodes 24. Likewise, probes extending from the probe card come into contact with the ground electrode pads 23, whereby the ground electrodes 25 are grounded. Minute beams, coming out of apertures which have a voltage applied to the deflection electrodes 24 thereon, are deflected and intercepted by a round aperture plate that is not shown. Minute beams, coming out of apertures which have no voltage applied to the deflection electrodes 24 thereon, are irradiated to the sample 18 but not deflected.

According to the above description, one of each pair of electrodes is grounded, and the other electrode is brought to a ground potential or any other predetermined potential depending on whether a beam is on or off. When the beam is off, two different voltages other than a voltage of the ground level, for example, positive and negative voltages may be applied to the paired electrodes. When the beam is on, the same voltage, for example, the voltage of the ground level may be applied thereto. However, in this case, the paired electrodes on each aperture must be able to be mutually independently applied with a voltage. Unlike the ground electrodes, the deflection electrodes cannot be linked in common. The BAA device having one of each pair of electrodes grounded, like the one shown in Fig. 5, will be described below. The present invention can be adapted to any other type of BAA device.

With an increase in the degree of integration offered by LSIs, the patterns of circuits become more microscopic. Lithography systems are therefore required to offer a higher resolution. One of methods for improving the resolution is a method of raising an acceleration voltage used to accelerate charged particles (electrons). When the acceleration voltage is raised, scattering of incident charged particles (electrons) in a resist is suppressed. Moreover, reflection of particles from the substrate can be suppressed. However, as long as a voltage to be applied to the deflection electrodes in the BAA device remains constant, when the acceleration voltage is raised, a magnitude of deflection by which a charged-particle beam is deflected decreases nearly proportionally. For ensuring a magnitude of deflection equivalent to the one attained with the acceleration voltage not raised, a higher voltage must be applied to the deflection electrodes. However, when the applied voltage is raised, it takes much time to settle an output of a drive circuit for outputting a deflection (on or off) signal. This hinders quick operations. When the acceleration voltage for accelerating the charged-particle beam is raised, the speed of the on-off operation performed in the BAA device must be lowered. This leads to a decreased throughput. Unless the speed of the on-off operation performed in the BAA device is lowered, a necessary magnitude of deflection cannot be attained. Consequently, minute beams cannot be brought to the off state reliably. Eventually, exposure is carried out in an unfavorable manner.

A way of keeping deflection efficiency constant despite a highly accelerated charged-particle beam without changing an applied voltage is presumably to extend the length of deflection electrodes. However, there is a limit to the feasible length of electrodes or a voltage that can be applied in terms of the manufacturing process of the BAA device.

Moreover, the BAA device produces numerous minute beams, for example, 512 minute beams. For drawing patterns of circuits with high quality, the on and off states of each minute beam must be controlled. In other words, if even one of the plurality of minute beams could not be controlled, the quality of drawn patterns of circuits would deteriorate. In particular, if any of the minute beams could not be brought to the off state, the minute beam would be uninterruptedly irradiated to a sample. This would bring about an adverse effect. When any one of the minute beams coming out of an aperture becomes uncontrollable, the BAA device must be replaced with a new one.

A charged-particle beam is irradiated to the BAA device 20, or more particularly, the aperture portion 21 all the time. A failure causing minute beams coming out of part of the apertures to become uncontrollable because of a damaged electrode or wiring or any other factor occurs with high probability. The failure is derived from, for example, a phenomenon that the electrodes 24 and 25 are fused thermally. The probability of a failure causing a minute beam coming out of one aperture to become uncontrollable due to the foregoing stress may be low. However, since the number of apertures is 512, the probability that one of the apertures fails is 512 times higher. This is a considerably high probability. The BAA device must therefore be renewed frequently. The use period (service life) of the BAA device is therefore very short. The shortness of the use period may be of an unacceptable level in practice. Furthermore, renewed invites an increase in the running cost of the electron beam lithography system.

### SUMMARY OF THE INVENTION

An object of the present invention is to improve the reliability of a BAA charged-particle beam lithography system and to enable drawing of microscopic LSI patterns with high quality at low cost.

To accomplish the above object, a charged-particle beam lithography system in accordance with the present invention has a multilayered BAA device.

To be more specific, the charged-particle beam lithography system in accordance with the present invention comprises a beam source, a blanking aperture array, a deflection unit, a convergence unit, and an exposure control circuit. The beam source generates a charged-particle beam. The blanking aperture array includes a plurality of apertures and electrodes, each pair of which is mutually opposed, across each aperture. An on-off signal is applied to deflection electrodes on the apertures, whereby it can control whether minute charged-particle beams coming out of the apertures are irradiated to a sample. The deflection unit deflects the minute charged-particle beams coming out of the blanking aperture array. The convergence unit converges the minute charged-particle beams coming out of the blanking aperture array on the sample. The exposure control circuit controls a signal to be applied to the electrodes on the apertures of the blanking aperture array according to an exposure pattern. The blanking aperture array has a plurality of accumulated BAA substrates. Each BAA substrate has a plurality of apertures bored therein and has the electrodes formed on one side thereof.

According to the present invention, for example, n BAA substrates having deflection electrodes, of which lengths (height) in a direction perpendicular to the substrates are the same, formed thereon may be layered. In this case, advantages to be exerted are the same as those provided when the height of the deflection electrodes is made n times larger than that of conventionally adopted deflection electrodes. Consequently, only a one-n-th of a voltage conventionally applied to the deflection electrodes is needed in order to attain the same magnitude of deflection as the conventionally attained magnitude. Eventually, an output voltage of a drive circuit for outputting a deflection signal can be lowered to a one-n-th. This leads to a higher driving rate and higher drawing rate. When the same voltage as that conventionally applied is applied to the deflection electrodes, a magnitude of deflection that is n times higher can be attained. Even when an acceleration voltage used to accelerate a charged-particle beam is raised, a sufficient magnitude of deflection can be attained. High-resolution patterns can therefore be drawn without a decrease in a throughput. In practice, the output voltage of the drive circuit should preferably be lowered to an intermediate level so that the high-resolution patterns can be drawn more quickly.

Moreover, when a plurality of BAA substrates is included, it means that the electrodes on the blanking apertures are redundant. If the electrodes of the first-layer BAA substrate were fused with heat and failed, the electrodes of the BAA substrates of the other layers would continue to function. The minute beams can be deflected without fail. The blanking aperture array should therefore be designed so that even if the electrodes of the BAA substrate of one layer fails, the minutes beams can be deflected with sufficient tolerance by applying a voltage to the electrodes on the BAA substrates of the remaining layers. When the blanking aperture array is thus designed, if the foregoing failure should occur, the BAA device would function satisfactorily and not fail. As mentioned above, when n BAA substrates are layered, if the same voltage as the conventionally applied one is applied to the deflection electrodes, n times large a magnitude of deflection is provided. A desired magnitude of deflection can therefore be realized easily. Consequently, the frequency of renewing the BAA device can be greatly reduced and a throughput provided by the lithography system can be improved. Moreover, the running cost of the lithography system can be minimized.

The arrays of pluralities of apertures in the plurality of BAA substrates should preferably be arranged in the same manner or arranged symmetrically with a plane between them. In this case, the BAA substrates are layered so that the corresponding apertures will coincide with one another. An electron beam is routed perpendicularly to the uppermost BAA substrate. As long as the arrays of apertures in the BAA substrates are arranged in the same manner or arranged symmetrically with a plane between them, an error between adjoining BAA substrates can be made very small. The heights of the electrodes on the apertures are not limited to any specific values. However, if the heights are the same, manufacturing can be simplified.

If the apertures in adjoining BAA substrates are arranged in the same manner, the BAA substrates are layered so that the surface of one BAA substrate will be opposed to the back of the other BAA substrate. If the arrays of apertures in adjoining BAA substrates are arranged symmetrically with a plane between them, the BAA substrates are layered so that the surface of one BAA substrate will be opposed to the surface of the other BAA substrate.

For the layering, the BAA substrates are aligned with one another visually or using an automatic alignment apparatus having the ability of image processing so that the corresponding apertures will coincide with one another. The BAA substrates are then bonded with one another. Any other means may be used to secure the BAA substrates.

An on-off signal to be applied to the deflection electrodes on the corresponding apertures in the plurality of BAA substrates should be a common signal output from one drive circuit. This would simplify the configuration of the drive circuit itself or the wiring linking the drive circuit and the BAA device.

The on-off signals to be applied to at least part of the deflection electrodes on the corresponding apertures in the plurality of BAA substrates may be a signal output from a different drive circuit so that the deflection electrodes can be controlled independently. In this case, it becomes possible to stop supply of the on-off signal to a deflection electrode that has failed. This structure leads to the complex configuration of the drive circuit itself or the complex wiring linking the drive circuit and the BAA device. However, higher redundancy can be attained. For example, when a deflection electrode on a certain aperture fails, a voltage to be applied to a deflection electrode on the corresponding apertures of the BAA substrates of the other layers is raised to compensate for the failure.

Moreover, it is hard to produce a charged-particle beam optical system and BAA device that is perfectly symmetrical or homogeneous. A position of deflection to which light is deflected varies depending on what path a charged-particle beam has tracked or through which blanking apertures the charged-particle beam has passed. Once such a positional deviation occurs, when the charged-particle beam is brought to the off sate, a position of irradiation to which the beam is irradiated shifts. Depending on such conditions as a type of resist and a blanking time, a resist that is photosensitive may react to the beam. If the on-off signal can be adjusted for each aperture, the positional deviation can be adjusted so that the on and off states of the beam can be controlled uniformly relative to all apertures.

Whether each deflection electrode operates normally can be checked by monitoring a current flowing into a drive circuit that outputs an on-off signal to be applied to the deflection electrodes on each BAA substrate. Otherwise, an output of a reflected electron detector included for alignment in the charged-particle beam lithography system may be utilized. Specifically, an output provided by the reflected electron detector when the on and off states of a minute beam coming out of each aperture are controlled is checked to see whether the deflection electrode on the aperture operates normally.

When a charged-particle beam lithography system is designed so that whether an on-off signal is supplied to a deflection electrode can be determined for each aperture, the system configuration becomes complex. Whether the on-off signal is supplied to a deflection electrode may be determined exclusively for a BAA substrate of a certain layer. Moreover, an electrode off means may be included for grounding all the deflection electrodes on a BAA substrate of a certain layer. The electrode off means is used to ground all the deflection electrodes on a BAA substrate that has entirely or partly failed, whereby a passing charged-particle beam is left unaffected by the failure.

A charged-particle beam is irradiated onto the BAA device. The charged-particle beam falls nearly entirely on the aperture portion of the BAA substrate of the first layer located on the incident side of the BAA device on which the charged-particle beam falls. In contrast, the BAA substrates of the second and subsequent layers are hardly damaged because the charged-particle beam, except part of the beam passing through the apertures, is intercepted by the BAA substrate of the first layer. The probability that the BAA substrate of the first layer fails is quite high. For this reason, a protective substrate is placed on the first-layer BAA substrate. The protective substrate has apertures of the same size as those in the first-layer BAA substrate (or of a larger size), and has a heavy metal film made of gold or the like formed on a portion of the surface to which the charged-particle beam is irradiated. Consequently, the damage the first-layer BAA substrate undergoes can be reduced greatly, and the probability that the first-layer BAA substrate fails can be lowered greatly. For producing the protective substrate, apertures identical to those in the BAA substrates are bored in a substrate, and a heavy metal film made of gold or the like is then formed according to a film forming means such as deposition or sputtering. The heat conductivity of gold is twice as high as that of silicon (Si). Moreover, since gold is a heavy metal, the reflectance of the protective substrate for a charged-particle beam is so high that the protective substrate will hardly absorb the beam. It will therefore hardly occur that the protective substrate is fused with heat energy.

The shape of minute beams coming out of the BAA device is determined by the shape of the apertures in the BAA substrate. If the apertures in the plurality of BAA substrates have the same shape, as long as the apertures in the layers perfectly coincide with one another, the shape of the minute beams will be the same as that of the apertures. If the positions of the apertures in the layers are deviated from one another, the shape of the minute beams becomes the shape of coincident portions of the apertures. The minute beams should preferably have the same shape. However, a positional deviation between adjoining layers of BAA substrates or an error in position of each aperture in one BAA substrate from another substrate brings about an error in shape of one minute beam from another. This poses a problem in that the minute beams may not have the same shape. The apertures in at least one (preferably, one) of the plurality of BAA substrates have a size defining the size of minute electron beams. The apertures in the other BAA substrates have a larger size. In this structure, the number of apertures defining the size of minute beams is so small that the error in shape of one minute beam from another beam can be minimized.

### BRIEF DESCRIPTION OF THE DRAWINGS

The present invention will be more clearly understood from the description as set below, with reference to the accompanying drawings, wherein:
Fig. 1 shows the configuration of an example of an electron beam lithography system in which the present invention can be implemented;
Fig. 2 shows an example of a blanking aperture array so as to explain the principles of a blanking aperture array (BAA) method;
Fig. 3A to Fig. 3C are explanatory diagrams concerning exposure specified according to the BAA method;
Fig. 4 shows the appearance of an actual BAA device;
Fig. 5 shows apertures in the actual BAA device in detail;
Fig. 6 is a sectional view of a conventional BAA device;
Fig. 7 is a sectional view of a BAA device in accordance with the first embodiment of the present invention;

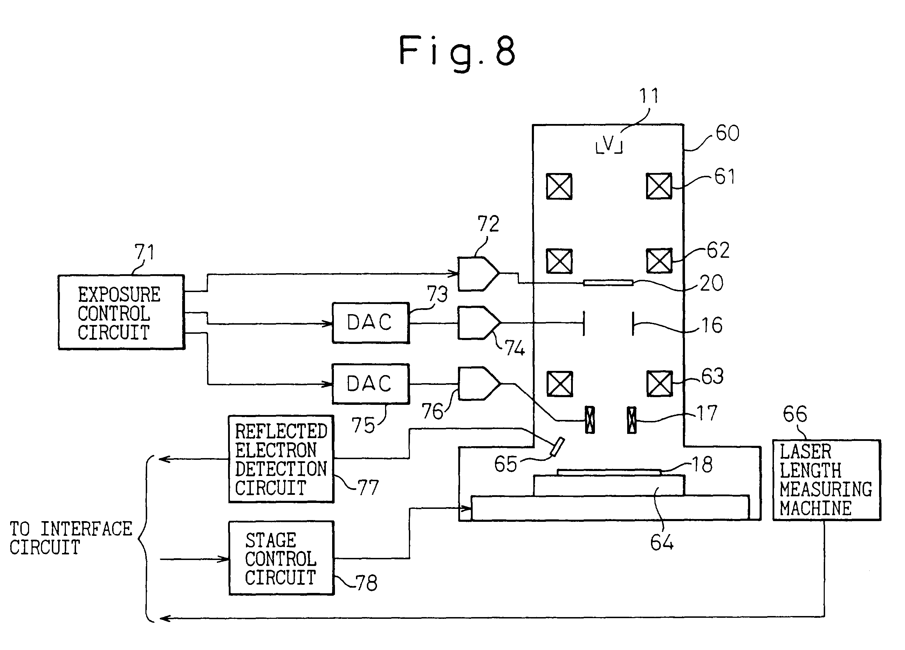

Fig. 8 shows the overall configuration of an electron beam lithography system of the first embodiment;

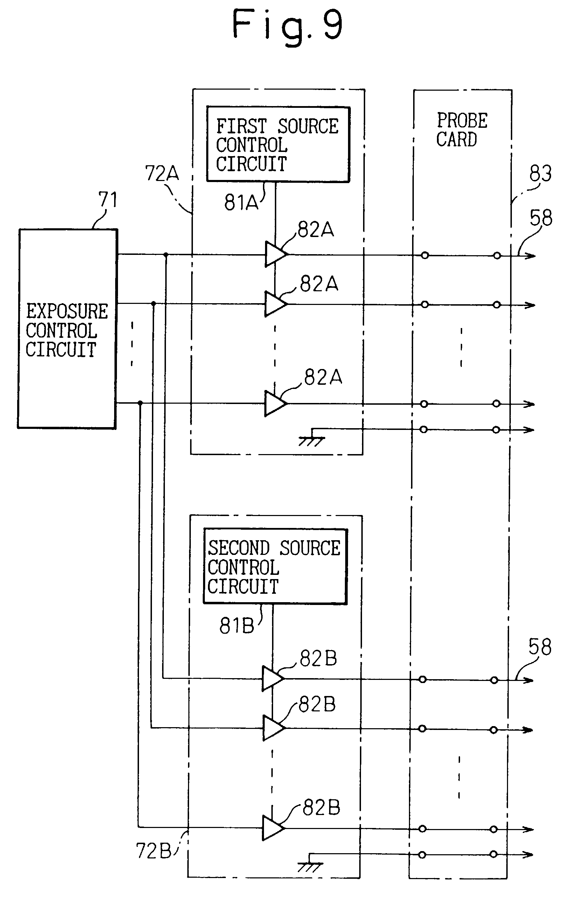

Fig. 9 shows a drive circuit for driving a BAA in the electron beam lithography system of the first embodiment;

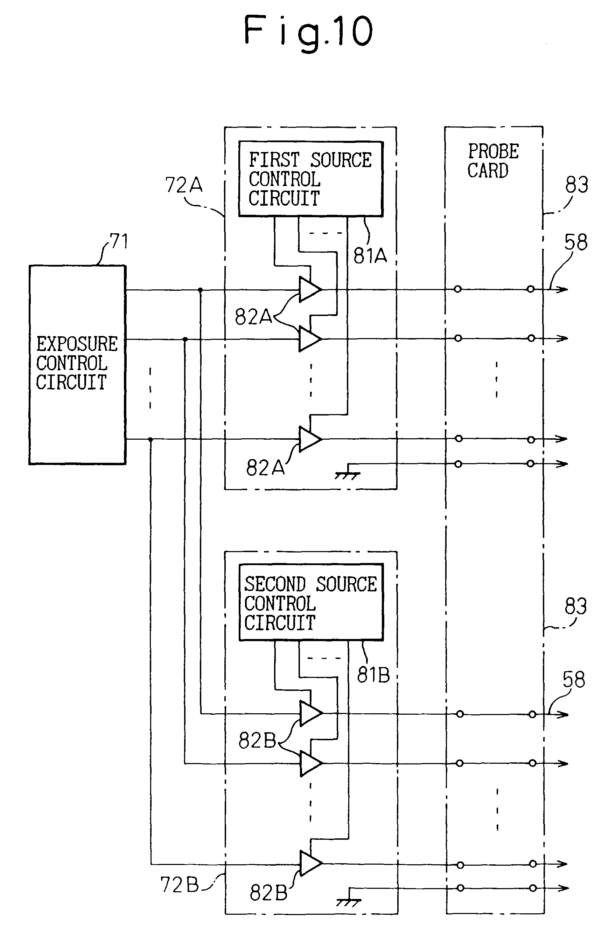

Fig. 10 shows another example of drive circuits for driving the BAA;

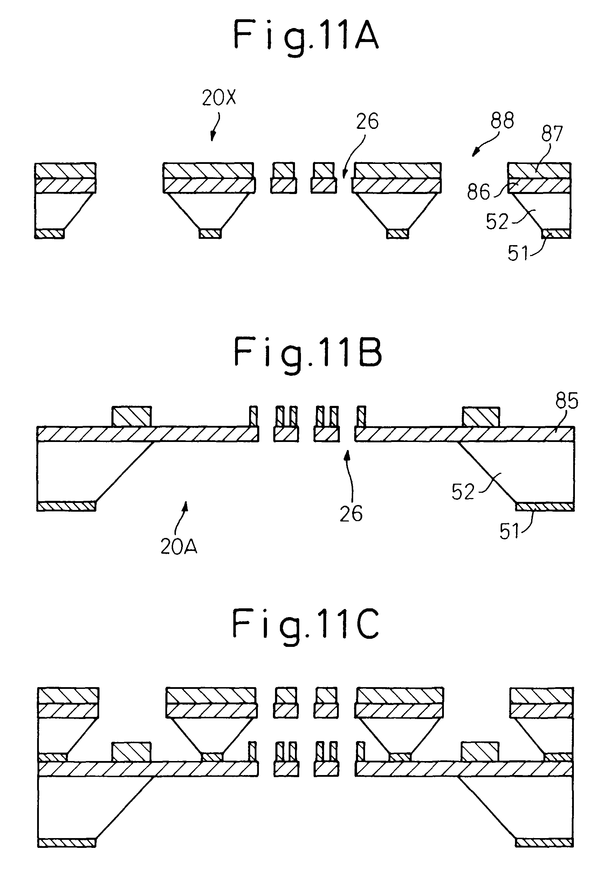

Fig. 11A to Fig. 11C are sectional views showing a protective substrate and uppermost BAA substrate of a BAA device, and an assembled state of the substrates in accordance with the second embodiment of the present invention;

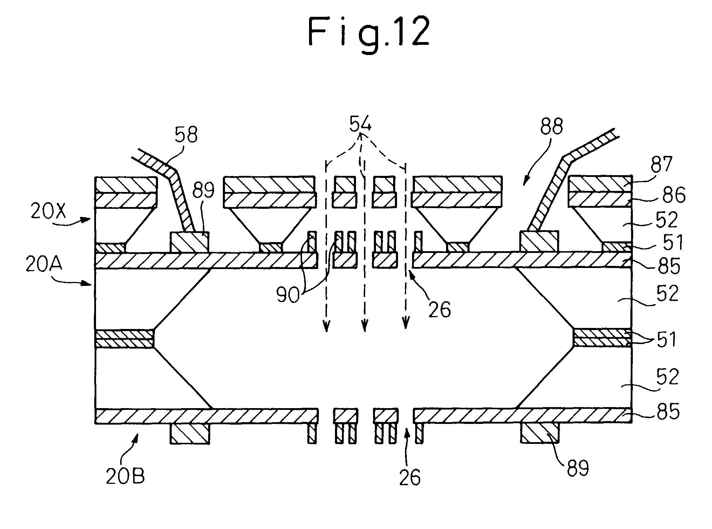

Fig. 12 is a sectional view of the BAA device of the second embodiment;

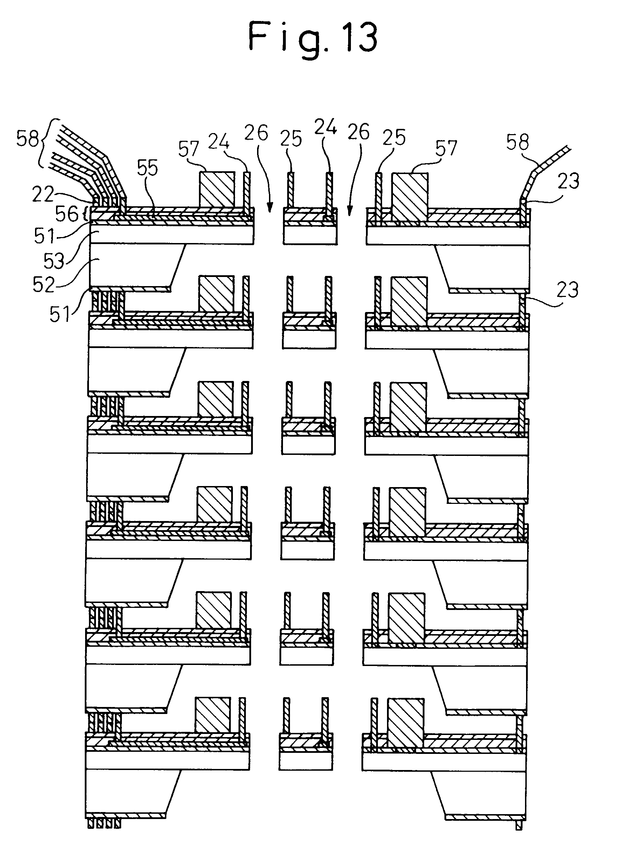

Fig. 13 is a sectional view of a BAA device in accordance with the third embodiment of the present invention; and

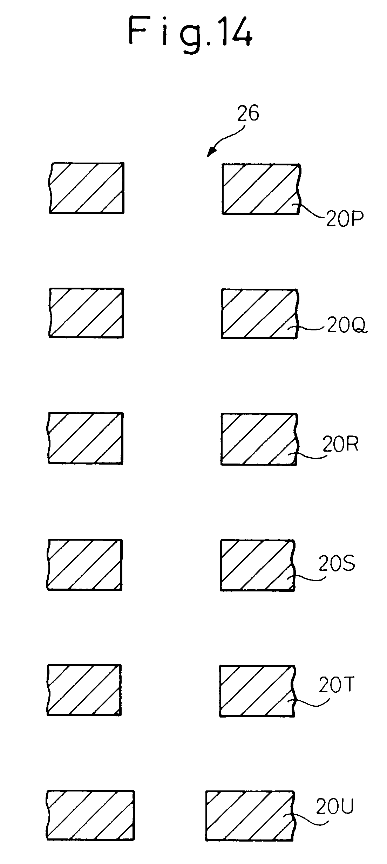

Fig. 14 shows an example in which the size of the apertures in part of BAA substrates is different from that in the other BAA substrates.

### DESCRIPTION OF THE PREFERRED EMBODIMENTS

Fig. 7 is a sectional view of a BAA device in accordance with the first embodiment of the present invention. The BAA device of the first embodiment is made by bonding the sides (backs), on which no electrodes are formed, of two BAA substrates 20A and 20B that are symmetrical to each other with a plane between them. The BAA substrates 20A and 20B have the same shape as the conventional BAA device shown in Fig. 4 to Fig. 6. One of the BAA substrates is immobilized and the other BAA substrate is placed on a precise movement apparatus. The BAA substrates are aligned with each other by observing them visually through a microscope or the like or by utilizing an image processing apparatus for automatically processing an image acquired through the microscope, so that all the apertures in one BAA substrate will coincide with those in the other. The BAA substrate itself is manufactured according to a conventional process. A description of the manufacturing process will be omitted. Since the arrays of apertures are arranged symmetrically with a plane between them, the components on one BAA substrate must coincide with counterparts high precisely. Moreover, stretching and contraction occur symmetrically. Therefore, when the BAA substrates are layered, the apertures in one BAA substrate must coincide with those in the other very precisely.

Supply of an on-off signal from a drive circuit to the BAA device and grounding of ground electrode pads are achieved using a probe card in the same manner as they are conventionally. The BAA device shown in Fig. 7 has deflection electrode pads 22 and ground electrode pads 23 formed on both sides thereof. Probes 58 extending from the probe card must be brought into contact with the electrodes 22 and 23 on both the sides of the BAA device. An electron beam 54 falls perpendicularly on the surface of the BAA device.

Fig. 8 shows the overall configuration of a BAA electron beam lithography system having the BAA device 20 of the first embodiment. There is shown a column 60, an electron gun 11, electromagnetic lenses (coils) 61, 62, and 63 for converging the electron beam or producing a parallel-ray beam, a sub deflector 16, a main deflector 17, and the BAA device 20 incorporated in the column 60. The apertures shown in Fig. 1 are not shown in Fig. 8. A sample (wafer) 18 is held movably on a stage 64. A laser length measuring unit 66 detects a magnitude of movement made by the stage 64.

A reflected electron detector 65 detects scattered electrons produced when an irradiated beam is reflected and scattered from the sample 18. The reflected electron detector 65 is used to detect a mark or the like on the sample 18 and to thus help positioning.

An exposure control circuit 71 generates a deflection signal to be applied to the BAA device 20, a sub deflector signal, and a main deflector signal. The deflection signal to be applied to the BAA device 20 is supplied to the BAA device via a drive circuit 72 and the probe card (not shown), and is then supplied to the deflection electrodes on the apertures. The sub deflector signal and main deflector signal that are deflection signals to be applied to the sub deflector 16 and main deflector 17 are converted into analog signals by D/A converters 73 and 75. The resultant analog signals are applied to the sub deflector 16 and main deflector 17 via drive circuits 74 and 76. An output of the reflected electron detector 65 is processed by a reflected electron detection circuit 77, and output to a control circuit for controlling the whole system via an interface circuit. Likewise, an output of the laser length measuring unit 66 is input to the control circuit for controlling the whole system via the interface circuit. Moreover, the control circuit for controlling the whole system supplies data indicating a magnitude of movement to be made by the stage to a stage control circuit 78. The stage control circuit 78 controls movements made by a stage moving mechanism according to the data.

Fig. 9 shows the configuration of the drive circuit 72 for outputting an on-off signal to be applied to the deflection electrodes in the BAA device 20. As illustrated, the drive circuit 72 consists of a first driving unit 72A for outputting an on-off signal to be supplied to the deflection electrode pads 22 on a first BAA substrate 20A, and a second driving unit 72B for outputting an on-off signal to be supplied to the deflection electrode pads 22 on a second BAA substrate 20B. The first driving unit 72A includes a group of driver devices 82A for generating a driving signal in response to the on-off signal sent from the exposure control circuit 71, and a first source control circuit 81A for supplying a supply voltage to the driver devices. Likewise, the second driving unit 72B includes a group of driver devices 82B for generating a driving signal in response to the on-off signal sent from the exposure control circuit 71 and a second source control circuit 81B for supplying a supply voltage to the driver devices. The group of driver devices 82A and the group of driver devices 82B output the same driving signal in response to the common on-off signal sent from the exposure control circuit 71. Owing to the first and second source control circuits 81A and 81B, the group of driver devices 82A and the group of driver devices 82B can be independently stopped outputting the driving signal. A ground-level signal can then be output. The outputs of the group of driver devices 82A and the group of driver devices 82B are applied to the deflection electrode pads 22 on the BAA substrates via the probe card 83. Moreover, the probes of the probe card 83 connected to the ground electrode pads on the BAA substrates are grounded in the first driving unit 72A and second driving unit 72B respectively.

In the BAA device 20 of the first embodiment, the lengths of the deflection electrodes 24 and ground electrodes 25 formed on the apertures 26 are twice as large as the conventionally adopted lengths. The voltages to be applied to the deflection electrodes 24 and ground electrodes 25 can therefore be set to half of the conventionally adopted voltages. Consequently, a driving rate can be raised.

Moreover, as mentioned previously, an electron beam is always irradiated to the deflection electrodes 24 and ground electrodes 25 on the first BAA substrate 20A on the side of the BAA device on which the electron beam falls. The deflection electrodes 24 and ground electrodes 25 are therefore stressed all the time. This leads to a failure stemming from fusion of the electrodes. As long as the voltages to be applied to the deflection electrodes 24 and ground electrodes 25 are set to the conventionally adopted levels, if the deflection electrodes 24 and ground electrodes 25 on some apertures in the upper BAA substrate 20A fail, the BAA device can still be used. Specifically, if the deflection electrodes 24 and ground electrodes 25 on some apertures in the upper BAA substrate 20A fail, minute beams coming out of the apertures cannot be brought to the off state. Nevertheless, since the lower BAA substrate can bring the coming minute beams to the off state, the BAA device can still be used as it is.

Incidentally, the deflection electrodes 24 and ground electrodes are located close together. When a failure occurs because of fusion of the electrodes, the fused deflection electrode 24 and ground electrode 25 are short-circuited. This causes a large current to flow from the driver devices 82A and 82B. The first and second source control circuits 81A and 81B are therefore provided with a current monitoring mechanism. When it is detected that a current equal to or larger than a predetermined current flows out, the outputs of the driver devices 82A or 82B are set to the ground level. Normally, the probability that the electrodes on the first upper BAA substrate 20A fail is higher. The current monitoring mechanism may therefore be incorporated in the first source control circuit 81A alone.

Moreover, another method of detecting a failure occurring in the BAA device 20 is a method making the most of the reflected electron detector 65 and reflected electron detection circuit 77. An on-off signal for bringing minute electron beams, which come out of, for example, all the apertures in all the BAA substrates, to the off state is output in order to detect reflected electrons. If reflected electrons are detected in this state, it means that there are minute electron beams that do not enter the off state. The minute beams coming out of the apertures are brought to the on and off states orderly one by one, whereby a change in reflected electrons is detected. A minute beam not causing the reflected electrons to change is a normally-on minute beam or a minute beam that never enters the on state. The position of the minute beam is recorded. Thereafter, one of the group of driver devices 82A and the group of driver devices 82B is stopped outputting using the first and second source control circuits 81A and 81B. The same operation as the above one is then performed on the minute beam. Consequently, whichever of the BAA substrates has failed can be recognized, and whether the failure is caused by a normally-on minute beam or a normally-off minute beam can be recognized. When each BAA substrate fails because of a plurality of normally-on minute beams, the normally-on minute beams or minute beams that never enter the on state cannot be specified perfectly according to this method. If the number of such minute beams can be specified based on the intensity of reflected electrons, failing parts can be specified very successfully.

When the number of minute beams that become uncontrollable and come out of one BAA substrate exceeds a predetermined value, an on-off signal to be applied to the failing BAA substrate is set to the ground level using the first source control circuit 81A or second source control circuit 81B. Herein, the predetermined number of uncontrollable minute beams varies depending on the nature or degree of a failure.

In the configuration shown in Fig. 9, the outputs of the driver devices can be set to the ground level in units of a group. As shown in Fig. 10, the drive circuit may be designed so that the outputs of the driver devices can be independently grounded. In this configuration, the BAA device can be controlled according to a failure.

In the first embodiment, a pair of BAA substrates that are mutually symmetric with a plane between them is layered symmetrically. Alternatively, as described later, another substrate may be layered on both the BAA substrates.

Fig. 11A to Fig. 11C are explanatory diagrams concerning a protective substrate and an upper BAA substrate 20A constituting a BAA device in accordance with the second embodiment of the present invention, and a process of manufacturing the BAA device.

As mentioned previously, an electron beam is always irradiated to the deflection electrodes 24 and ground electrodes 25 on the first BAA substrate 20A on the side of the BAA device on which the electron beam falls. The deflection electrodes 24 and ground electrodes 25 are therefore stressed, and likely to fail because of fusion. The BAA device of the second embodiment includes therefore, in addition to the same components as those of the first embodiment, a protective substrate 20X that is placed on the first BAA substrate 20A.

Fig. 11A shows the structure of the protective substrate 20X. Apertures are bored in a silicon substrate 52 so that they will coincide with the apertures 26 in the BAA substrates 20A and 20B. Moreover, holes 88 are bored through which the probes 58 extending from the probe card are passed. A thermal oxide 51 and oxide 86 are formed on the silicon substrate 52. A heavy metal layer 87 made of gold or the like is formed on the oxide 86. The apertures in the heavy metal layer 87 coincident with the apertures 26 are a bit larger than the apertures 26. The heavy metal layer 87 can be grounded.

Fig. 11B shows the first BAA substrate 20A that is identical to the one in the first embodiment.

The protective substrate 20X and the upper BAA substrate 20A are bonded to each other with the apertures 26 aligned with the apertures in the heavy metal layer 87. This results in a unit shown in Fig. 11C.

Furthermore, the lower BAA substrate 20B identical to the BAA substrate of the first embodiment is aligned with and bonded to the unit. This results in a BAA device like the one shown in Fig. 12 that has the protective substrate 20X, upper BAA substrate 20A, and lower BAA substrate 20B layered. Connections between the deflection electrode pads 22 and ground electrode pads 23 on the upper BAA substrate 20A and the probes of the probe card are achieved by passing the probes through the holes 88. Connections between the deflection electrode pads and ground electrode pads 23 on the lower BAA substrate 20B and the probes of the probe card are identical to those in the first embodiment.

Heavy metals to be made into the protective substrate 20X include, aside from gold, tantalum (Ta) and tungsten (W). The heavy metal layer 87 that is grounded will not affect the trajectory of an electron beam, but intercepts the electron beam irradiated to the portion other than the apertures 26. However, the electron beam irradiated to the deflection electrodes 24 and ground electrodes 25 and the wirings formed on the upper BAA substrate 20A and lower BAA substrate 20B is intercepted almost completely. Gold has such a high reflectance that an incident electron beam is reflected upward. The temperature therefore hardly rises. Moreover, the heat conductivity of gold is so high that heat generated by an incident electron beam is conducted to another portion (for example, the housing). Fusion or the like will therefore not take place.

Even in the second embodiment, another substrate may be layered on both the BAA substrates. A protective substrate may then be placed on the uppermost BAA substrate.

Fig. 13 shows the structure of a BAA device in accordance with the third embodiment. As illustrated, the BAA device of the third embodiment has six identical BAA substrates layered orderly. The size of the apertures 26 or the height of the deflection electrodes 24 and ground electrodes 25 may be varied depending on the layer. However, the positions of the apertures are the same among layers.

Each BAA substrate has through holes bored with the deflection electrode pads 22 and ground electrode pads 23 formed around them on both sides of the BAA substrate. Since the BAA substrates are layered, the electrode pads on the lower side of an upper BAA substrate are connected to the electrode pads on the upper side of a lower BAA substrate. The probes 58 extending from the probe card are brought into contact with the deflection electrode pads 22 and ground electrode pads 23 on the uppermost BAA substrate. A common on-off signal is supplied to the BAA substrates.

When the number of layered BAA substrates is as large as that in the third embodiment, voltages to be applied to the deflection electrodes 24 and ground electrodes on each BAA substrate can be reduced greatly. Moreover, a driving rate can be improved greatly.

Moreover, as shown in Fig. 9 or Fig. 10, a driver for generating the on-off signal to be supplied to each BAA substrate may be included separately so that the on-off signal can be supplied independently to the deflection electrode pads 22 and ground electrode pads 23 on each BAA substrate. The voltages to be applied are reduced to one-fifth of the conventional values. Nevertheless, when the five substrates are actuated, the same magnitude of deflection as the conventionally available one is available. The remaining one substrate is used as an auxiliary substrate. When any of the other BAA substrates fails, the on-off signal to be supplied to the failing BAA substrate is set to the ground level. The on-off signal is supplied to the auxiliary BAA substrate. This structure leads to a greatly improved driving rate. Moreover, the service life of the BAA device is improved greatly.

In Fig. 13, the apertures 26 in all the BAA substrates are mutually identical. However, the apertures 26 need not be mutually identical. Fig. 14 shows a variant in which the apertures 26 in part of the BAA substrates are different from those in the other BAA substrates. Only one aperture in each BAA substrate is shown, but the electrodes and others are not shown. As illustrated, the apertures in the lowermost BAA substrate 20U out of six BAA substrates 20P to 20U are smaller than those in the other five BAA substrates. The apertures 26 determine the size of minute beams. When all the apertures in the BAA substrates have the same size, if the apertures in the layers are perfectly coincident with one another, the shape of the minute beams is the same as that of the apertures. However, if the positions of the apertures are deviated among the layers, the shape of the minute beams becomes the shape of coincident portions of the apertures. The minute beams should preferably have the same shape. Positional deviations among the layers of BAA substrates or an error in position of each aperture in each BAA substrate brings about an error in shape of each minute beam. This poses a problem in that the shapes of the minute beams are not the same. As shown in Fig. 14, the apertures in the lowermost BAA substrate 20U alone are set to the same size as a desired size of minutes beams. The apertures in the other BAA substrates 20P to 20T are made slightly larger. This structure helps minimize the adverse effect of the error occurring in alignment or the positional deviations among the apertures in the BAA substrates. Consequently, minute beams of the desired size are irradiated.

Incidentally, a protective substrate may be placed on the uppermost BAA substrate shown in Fig. 13, or BAA substrates symmetrical to each other with a plane between them may be placed as a lower layer.

As described so far, according to the present invention, even when the acceleration voltage used to accelerate a charged-particle beam is raised, the on and off states of the beam can be controlled at the same driving rate as the conventionally adopted driving rate. Consequently, more microscopic LSIs enjoying a high degree of integration can be exposed at a high speed with high quality ensured. Moreover, a BAA device has a redundant structure. If part of the BAA device fails, the BAA device need not be renewed but can still be used as it is. This leads to a long service life of the BAA device. Moreover, the reliability and throughput of the BAA device are improved, and the running cost thereof is decreased.

## Claims

1. A charged-particle beam lithography system, comprising:
a beam source (11) for generating a charged-particle beam;
a blanking aperture array (20) having a plurality of apertures (26) and electrodes (24, 25) each pair of which is opposed to each other on each aperture, whether said charged-particle beam passing through each aperture is irradiated to a sample being controllable using an on-off signal to be applied to a deflection electrode on each aperture;
a deflection unit (16, 17) for deflecting said charged-particle beam passing through said blanking aperture array;
a convergence unit (19) for converging said charged-particle beam passing through said blanking aperture array on the sample; and
an exposure control circuit (71) for controlling a signal to be applied to the electrodes on the apertures of said blanking aperture array according to an exposure pattern,
wherein said blanking aperture array has a plurality of layered BAA substrates (20A, 20B); and
wherein each BAA substrate has said plurality of apertures bored therein and has said electrodes formed on one side thereof.

2. A charged-particle beam lithography system according to claim 1, wherein said arrays of said plurality of apertures in said plurality of BAA substrates are aligned with each other or symmetrical to each other with a plane between them, and wherein said plurality of BAA substrates is layered so that the corresponding apertures will coincide with one another.

3. A charged-particle beam lithography system according to claim 2, wherein said charged-particle beam falls perpendicularly on said blanking aperture array.

4. A charged-particle beam lithography system according to any of claims 1 to 3, wherein at least part of said plurality of BAA substrates are layered so that one side of a BAA substrate will be opposed to or in contact with the other side of a subsequent BAA substrate.

5. A charged-particle beam lithography system according to any of claims 1 to 4, wherein at least part of said plurality of BAA substrates are layered so that one side of a BAA substrate will be opposed to the other side of a subsequent BAA substrate.

6. A charged-particle beam lithography system according to any of claims 1 to 5, wherein said plurality of BAA substrates is bonded to each other.

7. A charged-particle beam lithography system according to any of claims 1 to 6, wherein said on-off signal to be applied to said deflection electrodes on said corresponding apertures in said plurality of BAA substrates is a common signal.

8. A charged-particle beam lithography system according to any of claims 1 to 6, wherein said on-off signal to be applied to said deflection electrodes on said corresponding apertures in at least part of said plurality of BAA substrates is output from a different drive circuit and is independently controllable.

9. A charged-particle beam lithography system according to any of claims 1 to 8, wherein the length in a direction perpendicular to said plurality of BAA substrates of said electrodes is the same among said BAA substrates.

10. A charged-particle beam lithography system according to any of claims 1 to 8, wherein the length in the direction perpendicular to said plurality of BAA substrates of said electrodes is different among at least part of said plurality of BAA substrates.

11. A charged-particle beam lithography system according to any of claims 1 to 10, wherein said blanking aperture array includes a protective substrate lying on the side of said blanking aperture array on which said charged-particle beam falls, having apertures corresponding to said plurality of apertures in said plurality of BAA substrates; and having a heavy metal film formed on a portion thereof to which said charged-particle beam is irradiated.

12. A charged-particle beam lithography system according to claim 11, wherein said heavy metal is gold.

13. A charged-particle beam lithography system according to any of claims 1 to 12, further comprising an electrode off means for setting said deflection electrodes to a ground level irrespective of said on-off signal.

14. A charged-particle beam lithography system according to any of claims 1 to 13, wherein said corresponding apertures in at least one of said plurality of BAA substrates have a size determining the size of said electron beam, and said apertures in the other BAA substrates are larger than said apertures in at least one of said BAA substrates.
